**Europäisches Patentamt**

**European Patent Office**

**Office européen des brevets**

(19)

(11) Veröffentlichungsnummer: **0 395 906**
**A2**

(12) **EUROPÄISCHE PATENTANMELDUNG**

(21) Anmeldenummer: **90106564.9**

(22) Anmeldetag: **05.04.90**

(51) Int. Cl.⁵: **H03M 7/42**

(30) Priorität: **03.05.89 DE 3914589**

(43) Veröffentlichungstag der Anmeldung:
**07.11.90 Patentblatt 90/45**

(84) Benannte Vertragsstaaten:
**DE FR GB IT**

(71) Anmelder: **ROBERT BOSCH GMBH**
**Postfach 10 60 50**
**D-7000 Stuttgart 10(DE)**

(72) Erfinder: **Helldörfer, Reinhard, Dipl.-Ing. (FH)**
**Rosenstrasse**
**D-8523 Igelsdorf(DE)**
Erfinder: **Osterkamp, Eva, Dipl.-Ing. (FH)**
**Steinbacher Strasse 12**
**D-8501 Burgthann 2(DE)**
Erfinder: **Kanzler, Ulrich, Dipl.-Ing. (FH)**
**Heuweg 3**
**D-8504 Stein(DE)**
Erfinder: **Leinberger, Jürgen, Dipl.-Ing. (FH)**
**Gisellastrasse 6**
**D-8500 Nürnberg(DE)**
Erfinder: **Zäuner, Edmund, Dipl.-Ing. (FH)**
**Haupstrasse 28**
**D-8434 Berching-Pollanten(DE)**

(54) **Verfahren zur Datenreduktion bei Strassennamen.**

(57) Es wird ein Verfahren zur Datenreduktion von Informationen, insbesondere von Straßennamen und Ortsnamen in Straßenplänen und Landkarten vorgeschlagen, bei dem anstelle dieser Informationen verkürzte Zeichenfolgen verwendet werden. Da sich in den Informationen häufig Wortsilben und Zeichenkombinationen wiederholen, wird für diese Wiederholungen ein besonderer Code festgelegt. Dieser Code ist in einer Referenzliste abgespeichert, die beliebig festgelegt werden kann, auch rekursiv. Beim Auslesen solcher verkürzter Zeichencodes kann anhand der Referenzliste der ursprüngliche Inhalt der Informationen rekonstruiert werden. Durch diese Art der Umcodierung der Informationen wird der benötigte Speicherbedarf erheblich reduziert.

FIG.3

EP 0 395 906 A2

## Verfahren zur Datenreduktion bei Straßennamen

Stand der Technik

Die Erfindung geht aus von einem Verfahren zur Datenreduktion von Informationen, die Straßennamen oder Ortsangaben enthalten nach der Gattung des Hauptanspruchs. Es ist schon bekannt, daß insbesondere in Straßenkarten oder Stadtplänen eine große Anzahl von Straßen-oder Ortsnamen abgelegt sind. Um das Auffinden eines bestimmten Namens zu erleichtern, sind in einer Tabelle den Straßen- und Ortsnamen Referenzzeichen zugeordnet. Diese Referenzzeichen sind in den Straßenkarten und Stadtplänen als vertikale und horizontale Linien eingetragen. Sie begrenzen jeweils ein bestimmtes Feld, in dem die gesuchte Straße oder der gesuchte Ort liegt. In einer Tabelle ist die Zuordnung zwischen den in einem Feld befindlichen Straßennamen und den Referenzzeichen festgelegt. Mit Hilfe der in der Tabelle abgelegten Referenzzeichen lassen sich die zu den gesuchten Namen gehörenden Straßen leichter auffinden. In der Tabelle sind damit alle Namen der Straße bzw. Orte mit einem verkürzten Zeichencode abgelegt.

Vorteile der Erfindung

Das erfindungsgemäße Verfahren mit den kennzeichnenden Merkmalen des Hauptanspruchs hat demgegenüber den Vorteil, daß auf dem Datenträger nicht die Informationen selbst, sondern ersatzweise ein Zeichencode abgespeichert wird, der insgesamt einen wesentlich geringeren Speicherplatzbedarf hat als die ursprüngliche Informationen.

Ein weiterer Vorteil besteht darin, daß sich häufiger wiederholende Silben oder Wortteile durch einen verkürzten Zeichencode ersetzt werden, wodurch sich der Speicherbedarf weiter reduziert.

Durch die in den Unteransprüchen aufgeführten Maßnahmen sind vorteilhafte Weiterbildungen und Verbesserungen des im Hauptanspruch angegebenen Verfahrens möglich.

Eine weitere Reduktion der Speicherkapazität ist vorteilhaft durch die rekursive Anwendung des Zeichencodes möglich, wobei bereits verkürzte Zeichencodes verwendbar sind.

Auch ist vorteilhaft, daß der verkürzte Zeichencode einer Referenzliste entnehmbar ist. Die Referenzliste ist übersichtlich erstellbar und nahezu beliebig erweiterbar. Sie ist selbst aus bereits definierten verkürzten Zeichencodes rekursiv aufbaubar, so daß mit nur wenigen bits ein umfangreicher Informationsspeicher erstellbar ist. Dabei ist auch als besonderer Vorteil anzusehen, daß die Codier- bzw. Dekordierzeit der Informationen wegen der tabellarischen Zuordnung relativ kurz ist.

Ein weiterer Vorteil ist, wenn die Länge der abgespeicherten Information durch ein Zählwort bestimmbar ist, das zusätzlich abgespeichert wird. Aufgrund des Zählwortes läßt sich beim Auslesen der Information der Decoder auf einfache Weise so steuern, daß er die entsprechende Codetabelle mit den verkürzten Zeichencodes direkt anwählt. Dadurch wird der zeitliche Aufwand für die Decodierung der Information verkürzt und die Dekodierung vereinfacht.

Durch die Verwendung des ASCII-Codes ist die Speicherung der Information sehr zuverlässig und mit geringem Aufwand verbunden, da für ein Zeichen schon 7 Bits ausreichen.

Da die elektronischen Massenspeicher heute relativ preiswert verfügbar sind, ist die Verwendung eines Halbleiterspeichers, eines Magnet- oder optischen Speichers besonders vorteilhaft. Diese Speicher sind einfach programmierbar und bei einer Änderung der gespeicherten Informationen leicht austauschbar.

Zur Optimierung des Speicherbedarfs ist besonders vorteilhaft, wenn mehrere Referenzlisten mit unterschiedlichen Codierungen verwendet werden, z.B. bei anderssprachigen Datensätzen. Je nach Art der zu speichernden Informationen führt die eine oder andere Referenzliste zu noch geringerem Speicherbedarf.

Weitere Vorteile der Erfindung sind der Beschreibung entnehmbar.

Zeichnung

Ein Ausführungsbeispiel der Erfindung ist in der Zeichnung dargestellt und in der nachfolgenden Beschreibung näher erläutert. Es zeigen Figur 1 ein Ausführungsbeispiel für die abzuspeichernde Information, Figur 2 ein Beispiel für eine Referenzliste und Figur 3 ein Beispiel für einen gespeicherten Zeichenstring.

Beschreibung des Ausführungsbeispiels

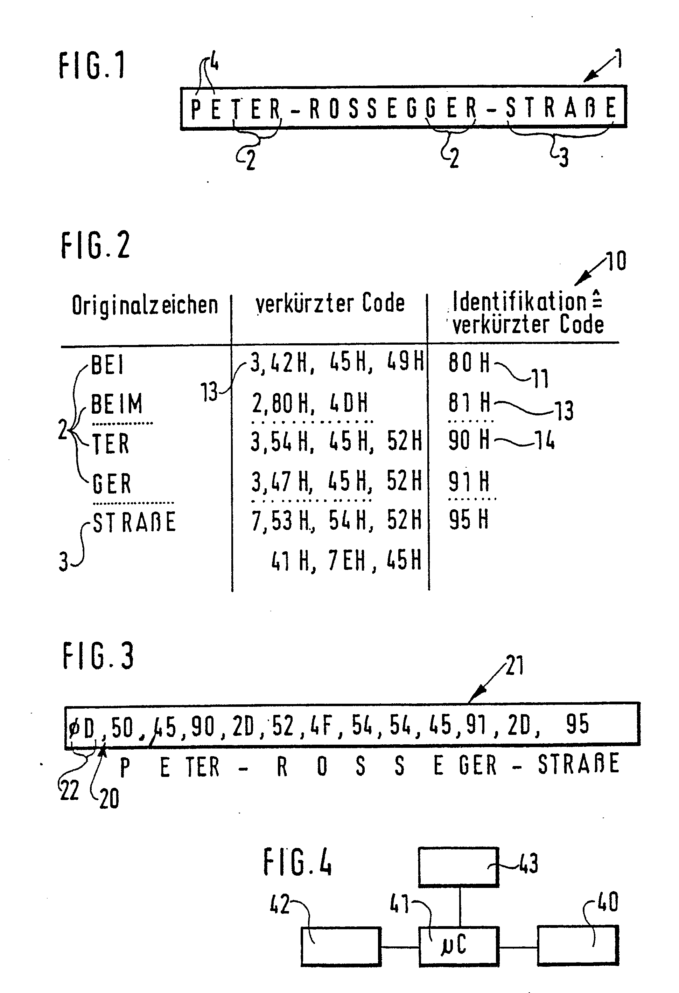

In Figur 1 ist als Beispiel für eine Information 1 der Straßenname PETER-ROSEGGER-STRAßE dargestellt. Der Name enthält einzelne Zeichen 4 wie P oder E sowie Zeichenfolgen 2 wie TER, GER oder den Begriff 3 wie STRAßE. Die in dem Beispiel angeführten Zeichenfolgen 2 und Begriffe 3 werden nun zur Verringerung des notwendigen Speicherbedarfs einem neuen Zeichencode zugewiesen, der in einer Referenzliste 10 dargestellt ist. In dieser Referenzliste 10 sind einige häufig auftretende Silben wie "BEI, BEIM, TER, GER und STRAßE" aufgeführt. Diese Zeichenfolgen sind einem verkürztem Zeichencode zugeordnet, der in diesem Beispiel mit den Ziffern 80 - 95 durchnumeriert wurde. Der Zeichencode ist beliebig wählbar. Sinnvoll ist eine fortlaufende Numerierung, da dann der Zeichencode selbst nicht unbedingt in der Tabelle abgespeichert werden muß.

Die Referenzliste 10 ist zusammen mit den gespeicherten Informationen in einem separaten Bereich des Speichermediums abgelegt. Werden die Informationen später ausgelesen, dann wird diese Referenzliste 10 ebenfalls ausgewiesen, so daß eine fehlerfreie Zuordnung zu den gespeicherten Zeichenfolgen gegeben ist.

In Figur 3 ist nun die in Figur 1 dargestellte Information als codierte abzuspeichernde Zeichenfolge 20 dargestellt. Die einzelnen Buchstaben dieses Ausführungsbeispiels sind nach dem bekannten ASCII-Code umgewandelt, sofern sie keine Zeichenfolge 2 oder Begriffe 3 bilden. Die Darstellung ist hexadezimal. Vor der eigentlichen Information 1 steht ein Zählwort, welches die Anzahl der abgespeicherten Zeichen angibt. In diesem Beispiel entspricht das Zeichen P der Straßenbezeichnung dem Code 50, das Zeichen E dem Code 45 und die Zeichenfolge TER dem verkürzten Zeichencode 90 gemäß der Referenzliste 10. Die weiteren Zeichen der Information 1 entsprechen den weiteren Zeichen der codierten Zeichenfolge 20. Die Bindestriche sind mit dem Code 2D ebenfalls abgespeichert. Wie aus diesem Beispiel ersichtlich ist, ist die ursprüngliche Information mit insgesamt 22 Zeichen reduziert worden auf insgesamt 13 Zeichen.

In Figur 2 ist eine Tabelle mit einer Referenzliste 10 dargestellt, die einige Beispiele für verkürzte Zeichencodes wiedergibt. So wird die Silbe BEI durch den verkürzten Zeichencode 80H dargestellt (vgl. rechte Spalte). Würde diese Silbe aus einzelnen Zeichen zusammengesetzt werden, dann hätte sie die Zeichen 42H, 45H, 49H sowie das vorgestellte Zählwort 3, da es aus drei Zeichen besteht. Bei der Dekodierung der hexadezimalen Zeichenfolge ist also aufgrund des Zählwortes erkennbar, daß zu der Silbe BEI lediglich drei Zeichen gehören.

Die Silbe BEIM setzt sich aus den Zeichenfolgen BEI und M zusammen. Da bereits für die Silbe BEI der verkürzte Zeichencode 80H gewählt wurde, läßt sich nun für die Silbe BEIM in verkürzter Schreibweise 80H, 4DH mit insgesamt zwei Zeichen schreiben.

Möchte man diese zwei Zeichen weiter kürzen, kann man sie einem neuen verkürzten Zeichencode, beispielsweise 81H zuordnen. Die ursprünglichen vier Zeichen wurden zu einem Zeichen verkürzt.

Bei der Dekodierung muß zunächst geprüft werden, ob der Zeichencode im Bereich 80H ... 95H liegt (rechte Spalte der Tabelle). Hier wird kein Zählwort verwendet, da der Code nur aus einem Zeichen besteht.

Wäre die Darstellung 2, 80H, 4DH, dann erfolgt die Dekodierung zunächst gemäß der mittleren Spalte und dann für die 80H gemäß der rechten Spalte.

In weiterer Ausgestaltung der Erfindung ist vorgesehen, nicht eine Referenzliste 10 zu verwenden, sondern mehrere. Je nach Anwendungsfall kann es vorteilhaft sein, wenn unterschiedliche Zeichenfolgen mit verkürzenden Zeichencodes verwendet werden. Dadurch ist eine Speicheroptimierung möglich, die von einer Steuereinheit 41 sehr einfach überprüft werden kann. Die Steuereinheit 41 wird für die Speicherung der Informationen dann diejenige Referenzliste 10 aussuchen, mit deren Hilfe der geringste Speicherbedarf benötigt wird.

Diese Vorgehensweise ist insbesondere bei der Erstellung von sprachenabhängigen Varianten der Datensätze vorteilhaft verwendbar.

In Figur 4 ist ein Blockschaltbild für das Ausführungsbeispiel angegeben. Es weist eine als $\mu$C bezeichnete Steuereinheit 41 auf, die mit einer bekannten Eingabeeinheit 42 und einer Ausgabeeinheit 40 verbunden ist. Die Steuereinheit 41 ist weiter mit einem Speicher 43 verbunden, der die codierten Informationen 20 enthält. Die Steuereinheit 41 enthält alle zur Steuerung notwendigen Einrichtungen sowie die Encoder und Decoder.

## Ansprüche

1. Verfahren zur Datenreduktion von Informationen, die Straßenbezeichnungen oder Ortsangaben eines Straßenplanes enthalten, die mit Hilfe eines Codes auf einem Datenträger abgespeichert sind, dadurch gekennzeichnet, daß die Informationen (1) als Zeichenfolge (20) abgespeichert werden und daß die in den Informationen (1) enthaltenen und häufiger vorkommenden Zeichenfolgen , vorzugsweise Silben (2) eines Wortes oder Begriffes (3), einem verkürzten Zeichencode (11, 13) zugeordnet werden, der ersatzweise für die häufiger vorkommenden Zeichenfolgen (2, 3) auf dem Datenträger abgespeichert wird.

2. Verfahren nach Anspruch 1, dadurch gekennzeichnet, daß die verkürzten Zeichencodes (11, 13) rekursiv aus verkürzten Zeichencodes zusammensetzbar sind.

3. Verfahren nach einem der vorhergehenden Ansprüche, dadurch gekennzeichnet, daß der verkürzte Zeichencode (11, 13) und die dazugehörige Zeichenfolge einer Referenzliste (10) entnehmbar sind.

4. Verfahren nach einem der vorhergehenden Ansprüche, dadurch gekennzeichnet, daß zusätzlich zur abgespeicherten Zeichenfolge (20) ein Zählwort (22) abgespeichert wird.

5. Verfahren nach Anspruch 4, dadurch gekennzeichnet, daß das Zählwort (22) die Länge der Zeichenfolge (20) enthält.

6. Verfahren nach einem der vorhergehenden Ansprüche, dadurch gekennzeichnet, daß die Codierung der abzuspeichernden Zeichenfolge (20) nach dem ASCII-Code erfolgt.

7. Verfahren nach einem der vorhergehenden Ansprüche, dadurch gekennzeichnet, daß der Datenträger ein elektronischer Speicher, vorzugsweise ein ROM-, RAM-Speicher, ein Magnet- oder optischer Speicher ist.

8. Verfahren nach einem der vorhergehenden Ansprüche, dadurch gekennzeichnet, daß mehrere Referenzlisten (10) mit unterschiedlicher Codierung der Zeichenfolgen vorgesehen sind und daß zum Speichern und Auslesen der Informationen (1) die jeweilige Referenzliste (10) verwendet wird, die für die abzuspeichernde Zeichenfolge (20) den geringsten Speicherbedarf erfordert.

FIG.1

P E T E R - R O S S E G G E R - S T R A ß E

FIG.2

| Originalzeichen | verkürzter Code | Identifikation ≙ verkürzter Code |
|---|---|---|
| BEI | 3, 42H, 45H, 49H | 80 H |
| BEIM | 2, 80H, 4DH | 81 H |
| TER | 3, 54H, 45H, 52H | 90 H |
| GER | 3, 47H, 45H, 52H | 91 H |
| STRAßE | 7, 53H, 54H, 52H | 95 H |
| | 41 H, 7EH, 45H | |

FIG.3

øD, 50, 45, 90, 2D, 52, 4F, 54, 54, 45, 91, 2D,    95

P   E TER  -  R   O   S   S   E GER - STRAßE

FIG.4

µC